# EUROPEAN PATENT APPLICATION

(11) **EP 4 475 647 A1**
(43) Date of publication of application: **11.12.2024**
(21) Application number: 23755691.5
(22) Date of filing: 02.02.2023
(51) Int. Cl.: H10K 59/00

(54) **DISPLAY PANEL AND MANUFACTURING METHOD THEREFOR, AND DISPLAY DEVICE**

(30) Priority: 21.02.2022 CN 202210157157
(71) Applicant: Huawei Technologies Co., Ltd., Shenzhen, Guangdong 518129 (CN)
(72) Inventor: XIONG, Wei, Shenzhen, Guangdong 518129 (CN); LUO, Kun, Shenzhen, Guangdong 518129 (CN); JIANG, Congbiao, Shenzhen, Guangdong 518129 (CN); CHI, Shipeng, Shenzhen, Guangdong 518129 (CN); ZHAO, Pengfei, Shenzhen, Guangdong 518129 (CN)
(74) Representative: Körber, Martin Hans
(86) International application number: PCT/CN2023/074249
(87) International publication number: WO 2023/155687

(57) **Abstract**

This application provides a display panel, a preparation method therefor, and a display apparatus. A first display region of the display panel has an OLED pixel, a second display region has a Micro LED pixel, the Micro LED pixel has a light emitting region and a light transmission region, and a camera is disposed below the second display region. After the Micro LED pixel is used in the second display region, display pixels having a same area in the first display region and the second display region can be designed, to implement display effect consistency between the first display region and the second display region. Because a size of the Micro LED pixel for light emitting is small, it can be ensured that the Micro LED pixel has a large light transmission region, so that light transmittance of the second display region can be improved. In addition, a part of signal cables connected to the Micro LED pixels are disposed as transparent cables, so that the light transmittance of the second display region can be further improved.

## Description

### CROSS-REFERENCE TO RELATED APPLICATIONS

This application claims priority to Chinese Patent Application No. 202210157157.X, filed with the China National Intellectual Property Administration on February 21, 2022 and entitled "DISPLAY PANEL, PREPARATION METHOD THEREFOR, AND DISPLAY APPARATUS", which is incorporated herein by reference in its entirety.

### TECHNICAL FIELD

This application relates to the field of display technologies, and in particular, to a display panel, a preparation method therefor, and a display apparatus.

### BACKGROUND

With development of display technologies, a high screen-to-body ratio gradually becomes the mainstream of displaying. Various sensors are hidden under a screen of a terminal product as much as possible, to increase a screen-to-body ratio. Because a liquid crystal display needs a backlight module, a full screen solution in which a region of an under-screen camera is set while normal displaying is ensured cannot be implemented for the liquid crystal display. However, an organic light emitting diode (organic light emitting diode, OLED) that emits light actively does not require backlight, and the under-screen camera can be easily hidden under the screen. To increase an amount of light entering the camera, a size of an OLED pixel of the region of the under-screen camera needs to be reduced. However, light transmittance of the region of the under-screen camera is not ideal, affecting a photo shooting effect. In addition, because the size of the OLED pixel is reduced, aging of the OLED pixel is accelerated, and a ghost image fault is easily to occur in the region of the under-screen camera, affecting a display effect.

Therefore, a current solution for the under-screen camera mainly has two problems: 1. Because an anode of the OLED pixel is of metal, and driver circuit cables of the OLED are all of metal, a large amount of metal causes low transmittance, causing a poor photo shooting effect of the under-screen camera. 2. Reducing the size of the pixel to improve the transmittance accelerates aging of the OLED, and a ghost image is easily to occur, affecting the display effect.

### SUMMARY

This application provides a display panel, a preparation method therefor, and a display apparatus, to implement display effect consistency between a transparent region and a normal display region and improve transmittance of the transparent region.

According to a first aspect, this application provides a display panel, including: a substrate having a first display region and a second display region, a plurality of OLED pixels located in the first display region, and a plurality of Micro LED pixels fastened to the second display region. The first display region may surround the second display region, or the first display region may half surround the second display region. The first display region occupies a larger region in a display region of the display panel, and the second display region occupies a smaller region in the display region of the display panel. The second display region has a specific light transmission feature, and can implement imaging of an under-screen camera. The OLED pixel located in the first display region may use an active matrix manner. To be specific, the OLED pixel may include an OLED light emitting device and a pixel driver circuit. An anode of the OLED light emitting device is generally connected to the pixel driver circuit, and a cathode of the OLED light emitting device is connected to a constant potential. The pixel driver circuit may specifically include two thin film transistors and one capacitor, namely, 2T1C. Alternatively, a quantity of thin film transistors may be increased for the pixel driver circuit, for example, 3T1C, 4T1C, 5T1C, 6T1C, and 7T1C. Each Micro LED pixel located in the second display region has a light emitting region and a light transmission region, and the light transmission region can implement the light transmission feature of the second display region. After the OLED pixel is replaced with the Micro LED pixel in the second display region, display pixels having a same area in the first display region and the second display region can be designed, to implement display effect consistency between the first display region and the second display region. In addition, because a size of the Micro LED pixel for light emitting is small, reducing an area of the Micro LED pixel for light emitting can ensure that the Micro LED pixel has a large light transmission region, so that light transmittance of the second display region can be improved, and a photo shooting effect of a front-facing camera can be improved. The display panel may further include a plurality of signal cables located on the substrate. The plurality of signal cables are respectively connected to the Micro LED pixels, and are configured to provide a drive signal for the Micro LED pixel by using the signal cable. At least a part of the plurality of signal cables are transparent cables. A part of signal cables connected to the Micro LED pixels are disposed as transparent cables, so that the light transmittance of the second display region can be further improved.

In a possible implementation of this application, the Micro LED pixel may use a passive matrix manner. To be specific, no driver circuit needs to be disposed in the Micro LED pixel, and a Micro LED chip is directly disposed in the light emitting region and is led out by using the signal cable. In this way, a quantity of cables in the second display region can be reduced, and the light transmittance can be improved. The Micro LED chip disposed in the light emitting region of each Micro LED pixel may emit monochromatic light of different colors. For example, a Micro LED chip that emits red light, a Micro LED chip that emits blue light, a Micro LED chip that emits green light, and the like may be cyclically disposed.

In a possible implementation of this application, because the passive matrix manner is used in the second display region, and is different from the active matrix manner in the first display region, both connections and control of display pixels of the entire display panel are different. Therefore, a driver chip needs to be separately provided to cooperate with the passive matrix manner used by the Micro LED pixel in the second display region. A first driver chip connected to the OLED pixel and a second driver chip connected to the Micro LED pixel by using the plurality of signal cables may be disposed. In addition, to simplify cabling complexity, the second driver chip may be disposed on a frame adjacent to the second display region. For example, the second display region is disposed adjacent to an upper frame. In this case, the second driver chip may be disposed on the upper frame, and the first driver chip may be disposed on a lower frame.

In a possible implementation of this application, when the Micro LED pixel uses the passive matrix manner, the plurality of signal cables may include: a plurality of first signal cables connected to first electrodes of the Micro LED chips, and a plurality of second signal cables connected to second electrodes of the Micro LED chips. The first electrode that is of the Micro LED chip and that is connected to the first signal cable may be an anode of the Micro LED chip, and correspondingly, the second electrode that is of the Micro LED chip and that is connected to the second signal cable may be a cathode of the Micro LED chip; and vice versa. In addition, the plurality of first signal cables may be disposed as transparent cables, and the transparent cable can improve the light transmittance of the second display region. The plurality of second signal cables may be set to metal cables, and the metal cable can reduce a resistance of the cable.

In a possible implementation of this application, the plurality of second signal cables may be connected to each other to form a public electrode, so that second electrodes of the Micro LED chips are connected together, to load a same potential signal. For example, the potential signal may be a public potential signal. The plurality of first signal cables may be independent of each other, so that the first electrode of each Micro LED chip is connected to the second driver chip by using a respective first signal cable, to load the drive signal for display.

In a possible implementation of this application, the second signal cables that are connected to each other may be disposed at a same metal layer, to simplify the cabling complexity. In addition, the second signal cable may be prepared at a same metal layer as a metal element in the pixel driver circuit of the OLED pixel, for example, may be prepared at a same metal layer as a gate electrode of the thin film transistor, to reduce film layer arrangement. The first signal cables that are independent of each other may be disposed at at least one transparent electrode layer. In addition, the first signal cable may be prepared after a dielectric layer or a planarization layer is prepared by the pixel driver circuit of the OLED pixel, for example, may be prepared at a same transparent electrode layer as the anode of the OLED light emitting device. Because the transparent electrode layer is prepared after the metal layer, it may be considered that there is a first insulation medium layer between the metal layer and the transparent electrode layer.

In a possible implementation of this application, to improve the light transmittance of the second display region and simplify cabling complexity of each film layer, cabling may be performed in vertical space in a buried manner as much as possible. Therefore, the plurality of first signal cables may be disposed at at least two transparent electrode layers. In the buried manner, a dielectric layer needs to be used as electrical isolation. Therefore, a second insulation medium layer may be disposed between the transparent electrode layers. Specifically, the first insulation medium layer and the second insulation medium layer may reuse the dielectric layer in a preparation process of the OLED pixel. For example, after the gate electrode of the thin film transistor is formed in the first display region and the second signal cable is formed in the second display region to complete preparation of the metal layer, a first dielectric layer is prepared as the first insulation medium layer, source and drain electrodes of the thin film transistor are prepared in the first display region on the first dielectric layer, and each first signal cable at a transparent electrode layer at a first layer is prepared in the second display region on the first dielectric layer. Then, a second dielectric layer is prepared as the second insulation medium layer, one electrode of the capacitor is prepared in the first display region on the second dielectric layer, and each first signal cable at a transparent electrode layer at a second layer is prepared in the second display region on the second dielectric layer. Then, a planarization layer is prepared as the second insulation medium layer, the anode of the OLED light emitting device is prepared in the first display region on the planarization layer, and each first signal cable at a transparent electrode layer at a third layer (a top layer) is prepared in the second display region on the planarization layer.

In a possible implementation of this application, when a plurality of transparent electrode layers are disposed to prepare the first signal cable, to improve the light transmittance of the second display region, the first signal cable may be superimposed in vertical space as much as possible, in other words, there is an overlapping region in the vertical space as much as possible between first signal cables located at different transparent electrode layers. In addition, to maximize the light transmittance of the second display region, in a possible implementation of this application, the first signal cables located at the different transparent electrode layers may be disposed in a completely overlapped manner.

In a possible implementation of this application, the Micro LED chip may be a flip chip, to be specific, the first electrode and the second electrode of the Micro LED chip may be located on a same plane and face the substrate, so that the first electrode and the second electrode of the Micro LED chip may be directly soldered to a corresponding signal cable by using a solder ball. Specifically, because a part of the first signal cables and all second signal cables are disposed below the transparent electrode layer at the top layer, to facilitate contact between the solder ball and the signal cable, a first signal pin and a second signal pin that are located on a same plane as the transparent electrode layer at the top layer may be disposed, and the first signal cable and the second signal cable that are disposed below the transparent electrode layer at the top layer are respectively led to the same plane as the transparent electrode layer at the top layer by using the first signal pin and the second signal pin. The second signal cable may be connected to the first signal pin by using a conductive material filled in a first connection hole that penetrates the first insulation medium layer and the second insulation medium layer, and a first signal cable at a transparent electrode layer at a non-top layer may be connected to the second signal pin by using a conductive material filled in a second connection hole that penetrates the second insulation medium layer.

In a possible implementation of this application, the display panel may further include a pixel definition layer located on the substrate. The pixel definition layer has a plurality of openings and a plurality of grooves. Each opening penetrates the pixel definition layer in a vertical direction and is located in the first display region, and is configured to limit a position of the OLED light emitting device. OLED light emitting devices are located in the openings. Each groove is located in the second display region, and is configured to limit a position of the Micro LED chip. Each groove can expose a light emitting surface of the Micro LED chip. A material of the pixel definition layer has a light blocking function. Therefore, the pixel definition layer can electrically partition the OLED light emitting device in the first display region, and perform optical isolation on light emitting of each Micro LED chip in the second display region. Therefore, a height of the pixel definition layer needs to be higher than the light emitting surface of each Micro LED chip.

In a possible implementation of this application, the display panel may further include a thin film encapsulation layer located on the substrate. The thin film encapsulation layer covers the OLED light emitting device, the Micro LED chip, and the pixel definition layer. The thin film encapsulation layer can protect the OLED light emitting device from being damaged by water vapor and oxygen, to improve use reliability. In addition, the thin film encapsulation layer can also protect the Micro LED chip, to improve use reliability of the Micro LED chip.

According to a second aspect, this application further provides a display apparatus, including: the display panel provided in the implementations of the first aspect of this application, and a camera disposed below a first display region of the display panel.

According to a third aspect, this application further provides a preparation method for a display panel, including: providing a substrate having a first display region and a second display region; then forming a plurality of signal cables on the substrate, where at least a part of the plurality of signal cables are transparent cables; then forming a plurality of Micro LED pixels in the second display region on the substrate, where each Micro LED pixel has a light emitting region and a light transmission region, and the Micro LED pixels are respectively connected to the plurality of signal cables; and finally, forming a plurality of OLED pixels in the first display region on the substrate.

Specifically, in the display panel prepared by using the foregoing preparation method, after the OLED pixel is replaced with the Micro LED pixel in the second display region, display pixels having a same area in the first display region and the second display region can be designed, to implement display effect consistency between the first display region and the second display region. Because a size of the Micro LED pixel for light emitting is small, it can be ensured that the Micro LED pixel has a large light transmission region, so that light transmittance of the second display region can be improved. In addition, a part of signal cables connected to the Micro LED pixels are disposed as transparent cables, so that the light transmittance of the second display region can be further improved.

In a possible implementation of this application, the Micro LED pixel may use a passive matrix manner. To be specific, no driver circuit needs to be disposed in the Micro LED pixel, and a Micro LED chip is directly disposed in the light emitting region and is led out by using the signal cable. In this way, a quantity of cables in the second display region can be reduced, and the light transmittance can be improved. The plurality of signal cables may include: a plurality of first signal cables connected to first electrodes of the Micro LED chips, and a plurality of second signal cables connected to second electrodes of the Micro LED chips. In addition, the plurality of first signal cables may be disposed as transparent cables, and the transparent cable can improve the light transmittance of the second display region. The plurality of second signal cables may be set to metal cables, and the metal cable can reduce a resistance of the cable. Further, the plurality of second signal cables may be connected to each other to form a public electrode, so that second electrodes of the Micro LED chips are connected together, to load a same potential signal. For example, the potential signal may be a public potential signal. The plurality of first signal cables may be independent of each other, so that the first electrode of each Micro LED chip is connected to a second driver chip by using a respective first signal cable, to load a drive signal for display.

In comparison with preparation of the OLED pixel in the first display region, the Micro LED pixel in the second display region uses the passive matrix manner. Therefore, a component such as the TFT does not need to be prepared in the second display region, and only a signal cable needs to be prepared. Specifically, in a process of preparing a pixel driver circuit of the OLED pixel, preparation of a signal cable in the second display region may be completed.

In a possible implementation of this application, the second signal cables that are connected to each other may be disposed at a same metal layer, to simplify cabling complexity. In addition, the second signal cable may be prepared at a same metal layer as a metal element in the pixel driver circuit of the OLED pixel, for example, may be prepared at a same metal layer as a gate electrode of a thin film transistor, to reduce film layer arrangement. The first signal cables that are independent of each other may be disposed at at least one transparent electrode layer. In addition, the first signal cable may be prepared after a dielectric layer or a planarization layer is prepared by the pixel driver circuit of the OLED pixel, for example, may be prepared at a same transparent electrode layer as an anode of an OLED light emitting device. Because the transparent electrode layer is prepared after the metal layer, it may be considered that there is a first insulation medium layer between the metal layer and the transparent electrode layer.

In a possible implementation of this application, to improve the light transmittance of the second display region and simplify cabling complexity of each film layer, cabling may be performed in vertical space in a buried manner as much as possible. Therefore, the plurality of first signal cables may be disposed at at least two transparent electrode layers. In the buried manner, a dielectric layer needs to be used as electrical isolation. Therefore, a second insulation medium layer may be disposed between the transparent electrode layers. Specifically, the first insulation medium layer and the second insulation medium layer may reuse the dielectric layer in a preparation process of the OLED pixel. For example, after the gate electrode of the thin film transistor is formed in the first display region and the second signal cable is formed in the second display region to complete preparation of the metal layer, a first dielectric layer is prepared as the first insulation medium layer, where source and drain electrodes of the thin film transistor are prepared in the first display region on the first dielectric layer, and each first signal cable at a transparent electrode layer at a first layer is prepared in the second display region on the first dielectric layer. Then, a second dielectric layer is prepared as the second insulation medium layer, one electrode of the capacitor is prepared in the first display region on the second dielectric layer, and each first signal cable at a transparent electrode layer at a second layer is prepared in the second display region on the second dielectric layer. Then, a planarization layer is prepared as the second insulation medium layer, where the anode of the OLED light emitting device is prepared in the first display region on the planarization layer, and each first signal cable at a transparent electrode layer at a third layer (a top layer) is prepared in the second display region on the planarization layer.

In a possible implementation of this application, when a plurality of transparent electrode layers are disposed to prepare the first signal cable, to improve the light transmittance of the second display region, the first signal cable may be superimposed in vertical space as much as possible, in other words, there is an overlapping region in the vertical space as much as possible between first signal cables located at different transparent electrode layers. In addition, to maximize the light transmittance of the second display region, the first signal cables located at different transparent electrode layers may be disposed in a completely overlapped manner.

In a possible implementation of this application, because a part of first signal cables and all second signal cables are disposed below the transparent electrode layer at the top layer, to facilitate contact between a solder ball and the signal cable, a first signal pin and a second signal pin that are located on a same plane as the transparent electrode layer at the top layer may be disposed, and the first signal cable and the second signal cable that are disposed below the transparent electrode layer at the top layer are respectively led to the same plane as the transparent electrode layer at the top layer by using the first signal pin and the second signal pin. The second signal cable may be connected to the first signal pin by using a conductive material filled in a first connection hole that penetrates the first insulation medium layer and the second insulation medium layer, and a first signal cable located at a transparent electrode layer at a non-top layer may be connected to the second signal pin by using a conductive material filled in a second connection hole that penetrates the second insulation medium layer. In a preparation process, after the transparent electrode layer at the top layer is prepared, the first connection hole that penetrates the first insulation medium layer and the second insulation medium layer (to be specific, penetrates the first dielectric layer, the second dielectric layer, and the planarization layer) may be formed through an etching process, the second connection hole that penetrates the second insulation medium layer (to be specific, penetrates the second dielectric layer and the planarization layer, or penetrates the planarization layer) may be formed through the etching process, and the first connection hole and the second connection hole are filled with the conductive material, to form the first signal pin and the second signal pin that are located on the same plane as the transparent electrode layer at the top layer. Then, solder balls may be respectively formed on the first signal pin, the second signal pin, and the first signal cables located at the transparent electrode layer at the top layer.

In a possible implementation of this application, the Micro LED chip may be a flip chip, to be specific, the first electrode and the second electrode of the Micro LED chip may be located on a same plane and face the substrate, so that the Micro LED chip is transferred to the solder ball in a huge quantity, and the first electrode and the second electrode of the Micro LED chip may be directly soldered to a corresponding signal cable through a bonding process by using the solder ball.

In a possible implementation of this application, after the Micro LED chip in the second display region is fastened, a pixel definition layer may be prepared on the substrate. A material of the pixel definition layer has a light blocking function. Therefore, the pixel definition layer can electrically partition the OLED light emitting device in the first display region, and perform optical isolation on light emitting of each Micro LED chip in the second display region. Therefore, a height of the pixel definition layer should be higher than a light emitting surface of each Micro LED chip. To improve the light transmittance of the second display region, the pixel definition layer needs to dig a hole in the light transmission region of the Micro LED pixel, to avoid blocking light transmission. The pixel definition layer may dig a groove in the light emitting region of the Micro LED pixel, to expose the light emitting surface of the Micro LED chip.

In a possible implementation of this application, after the pixel definition layer is prepared, organic light emitting functions layers (for example, a hole transport layer, an electron blocking layer, an organic light emitting layer, a hole blocking layer, and an electron transport layer) and a cathode of the OLED light emitting device in the first display region may be evaporated, to complete preparation of the OLED pixel in the first display region.

In a possible implementation of this application, after the pixel definition layer is prepared, a thin film encapsulation layer that covers the OLED light emitting device, the Micro LED chip, and the pixel definition layer may be further formed. The thin film encapsulation layer can protect the OLED light emitting device from being damaged by water vapor and oxygen, to improve use reliability. In addition, the thin film encapsulation layer can also protect the Micro LED chip, to improve use reliability of the Micro LED chip.

For a technical effect that can be achieved by any possible design in either the second aspect or the third aspect, refer to the technical effect that can be achieved by any possible design in the first aspect. Details are not described herein again. These aspects or another aspect of this application is clearer and more comprehensible in descriptions of the following embodiments.

### BRIEF DESCRIPTION OF DRAWINGS

FIG. 1 is a diagram of a top-view structure of a display apparatus according to an embodiment of this application;
FIG. 2 is a diagram of a cross-sectional structure of a display apparatus according to an embodiment of this application;
FIG. 3 is a diagram of a top-view structure of a display panel according to an embodiment of this application;
FIG. 4 is a diagram of a top-view structure of a second display region on a display panel according to an embodiment of this application;
FIG. 5 is a diagram of a specific structure of a second display region on a display panel according to an embodiment of this application;
FIG. 6 is a diagram of a cross-sectional structure of a display panel according to an embodiment of this application;
FIG. 7 is a diagram of a cross-sectional structure of another display panel according to an embodiment of this application;
FIG. 8 is a schematic flowchart of a preparation method for a display panel according to an embodiment of this application; and
FIG. 9a to FIG. 9e are respectively diagrams of cross-sectional structures after steps in a preparation method for a display panel are completed according to an embodiment of this application.

### DESCRIPTION OF EMBODIMENTS

To make objectives, technical solutions, and advantages of this application clearer, the following further describes this application in detail with reference to accompanying drawings.

Terms used in the following embodiments are merely intended to describe specific embodiments, but are not intended to limit this application. The terms "one", "a" and "this" of singular forms used in this specification and the appended claims of this application are also intended to include expressions such as "one or more", unless otherwise specified in the context clearly.

Reference to "an embodiment", "some embodiments", or the like described in this specification indicates that one or more embodiments of this application include a specific feature, structure, or characteristic described with reference to embodiments. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. The terms "include", "have", and their variants all mean "include but are not limited to", unless otherwise specifically emphasized in another manner.

In addition, same reference numerals in the figures represent same or similar structures. Therefore, repeated description thereof is omitted. Expressions of positions and directions in this application are described by using the accompanying drawings as examples. However, changes may also be made as required, and all the changes fall within the protection scope of this application. The accompanying drawings in this application are merely used to illustrate relative position relationships and do not represent an actual scale.

A display panel and a preparation method therefor, and a display apparatus that are provided in embodiments of this application may be used in various terminal devices, for example, may be used in an electronic device having a camera function, such as a smartphone, a tablet computer, or a palmtop computer (personal digital assistant, PDA). It should be noted that the display panel and the display apparatus provided in embodiments of this application are intended to include but are not limited to being used in these and any other terminal device of a suitable type.

The following describes the display panel and the preparation method therefor, and the display apparatus provided in this application in detail with reference to the accompanying drawings.

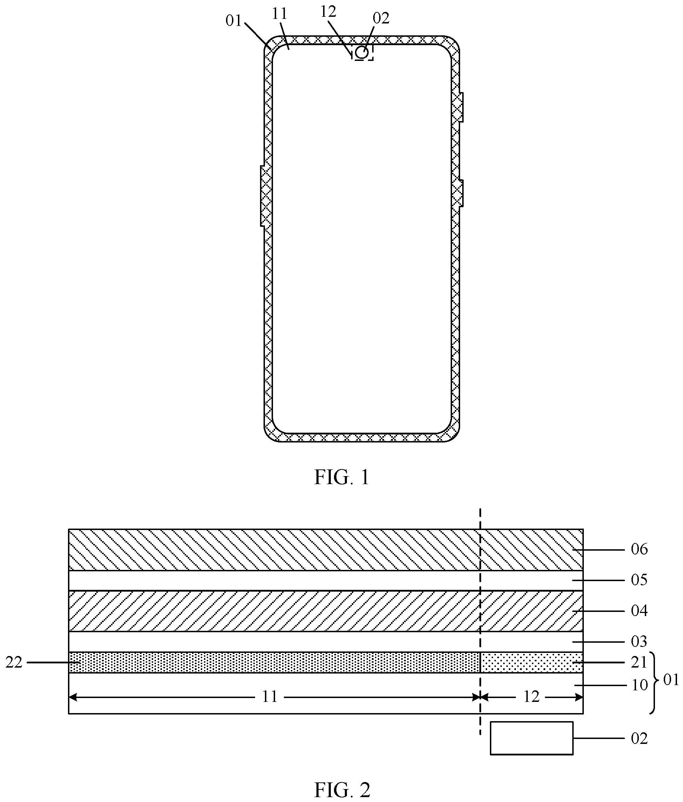

FIG. 1 is an example of a diagram of a top-view structure of a display apparatus according to an embodiment of this application, and FIG. 2 is an example of a diagram of a cross-sectional structure of a display apparatus according to an embodiment of this application. Refer to FIG. 1 and FIG. 2. In an embodiment of this application, to implement a full screen display function, the display apparatus includes: a display panel 01 having a first display region 11 and a second display region 12, and a camera 02 disposed below the second display region 12 of the display panel 01. The first display region 11 may surround the second display region 12, or the first display region 11 may half surround the second display region. The second display region 12 occupies a smaller region in a display region of the display panel 01, and may be referred to as a secondary screen. The secondary screen has a specific light transmission feature, and can implement imaging of an under-screen camera. The first display region 11 occupies a larger region in the display region of the display panel 01, may be referred to as a primary screen, and has a display pixel for implementing a conventional display function. In addition, the secondary screen includes a plurality of display pixels for implementing the conventional display function, so that a display picture synchronized with the primary screen can be implemented.

In this embodiment of this application, the secondary screen (the second display region 12) has a display pixel and a cabling design that are completely different from those of the existing primary screen (the first display region 11), so that transmittance and a display effect of a region of the under-screen camera can be improved, and an imaging effect of the under-screen camera is improved. Specifically, in this embodiment of this application, the display pixel of the first display region 11 may be an organic light emitting diode (organic light emitting diode, OLED) pixel, the display pixel of the second display region 12 may be a micro light emitting diode (micro light emitting diode, Micro LED) pixel, the Micro LED pixel has a light emitting region and a light transmission region, and the light transmission region can implement a light transmission feature of the second display region 12. After the OLED pixel is replaced with the Micro LED pixel in the second display region 12, display pixels having a same area in the first display region 11 and the second display region 12 can be designed, to implement display effect consistency between the first display region 11 and the second display region 12. Because a size of the Micro LED pixel for light emitting is small, it can be ensured that the Micro LED pixel has a large light transmission region, so that light transmittance of the second display region 12 can be improved. In addition, a part of signal cables connected to the Micro LED pixels may be further disposed as transparent cables, to further improve the light transmittance of the second display region 12. A detailed arrangement manner and a cabling design of the Micro LED pixels are described in detail in the following display panel provided in this application.

Refer to FIG. 2. In this embodiment of this application, in the display apparatus, a circular-polarizing filter 04 (circular-polarizing filter, c-Pol) is generally attached to a surface of the display panel 01 by using a first optical adhesive 03, to reduce reflection of ambient light. In addition, a cover plate 06 is attached to the circular-polarizing filter by using a second optical adhesive 05, to play a protection role. Specifically, the cover plate 06 may be a glass cover plate, or may be a resin cover plate. A material of the cover plate is not limited herein. Another component included in the display apparatus are not described in detail herein.

The following describes in detail a pixel arrangement manner and a cabling design of the display panel provided in this embodiment of this application.

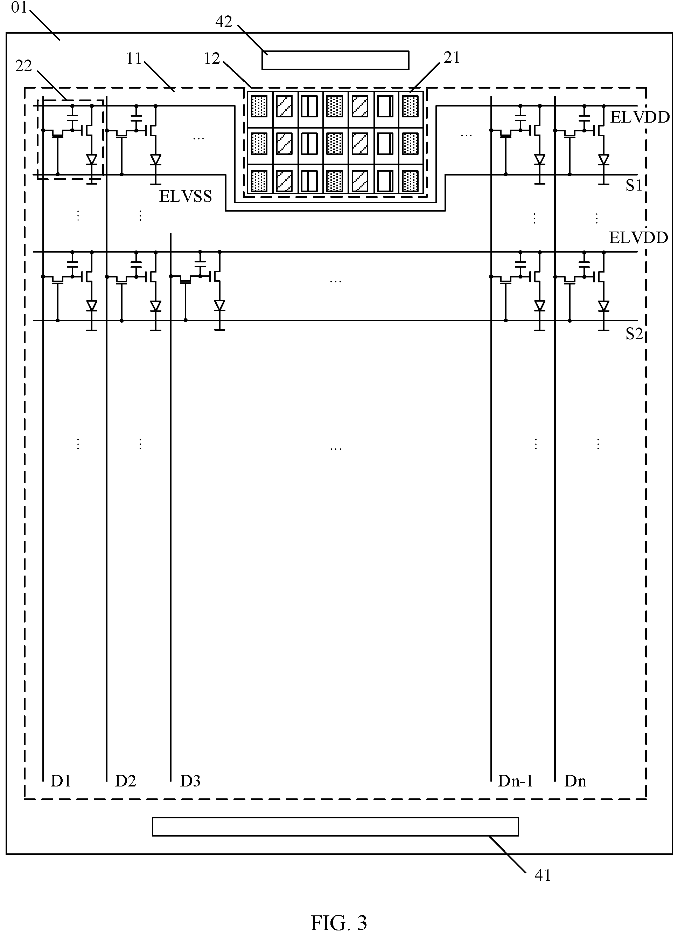

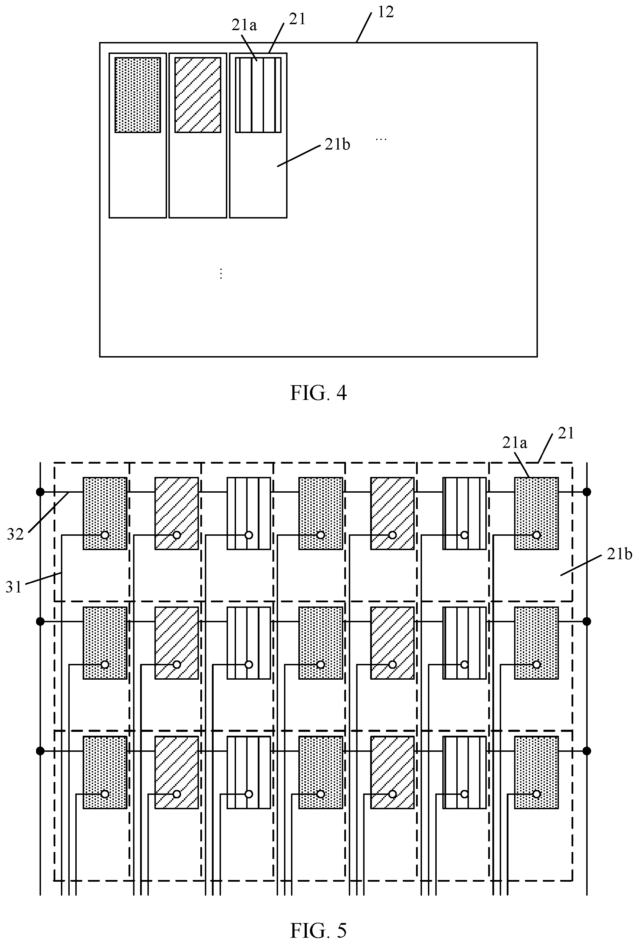

FIG. 3 is an example of a diagram of a top-view structure of a display panel according to an embodiment of this application, FIG. 4 is an example of a diagram of a top-view structure of a second display region on a display panel according to an embodiment of this application, and FIG. 5 is an example of a diagram of a specific structure of a second display region on a display panel according to an embodiment of this application.

Refer to FIG. 3. In an embodiment of this application, a display panel 01 includes a substrate 10 having a first display region 11 and a second display region 12, a plurality of OLED pixels 22 located in the first display region 11, and a plurality of Micro LED pixels 21 fastened to the second display region 12. The first display region 11 may surround the second display region 12, or the first display region 11 may half surround the second display region. The first display region 11 occupies a larger region in a display region of the display panel 01, and the second display region 12 occupies a smaller region in the display region of the display panel 01. The second display region 12 has a specific light transmission feature, and can implement imaging of an under-screen camera. The OLED pixel 22 located in the first display region 11 may use an active matrix (active matrix, AM) manner. To be specific, the OLED pixel 22 may include an OLED light emitting device and a pixel driver circuit. An anode of the OLED light emitting device is generally connected to the pixel driver circuit, and a cathode of the OLED light emitting device is connected to a constant potential. The pixel driver circuit may be specifically include two thin film transistors (thin film transistors, TFTs) and one capacitor (Cst), namely, 2T1C. Alternatively, a quantity of thin film transistors may be increased for the pixel driver circuit, for example, 3T1C, 4T1C, 5T1C, 6T1C, and 7T1C. In FIG. 3, an example in which the OLED pixel 22 in the first display region 11 uses a 2T1C structure is used. OLED pixels 22 in each row of OLED pixels 22 are all connected to one scanning signal line S, and OLED pixels 22 in each column of OLED pixels 22 are all connected to one data signal line D. In the active matrix manner, progressive scanning is performed on signals and data is written, to be specific, scanning signals are sequentially provided for scanning signal lines S from top to bottom, and data signals are sequentially written to data signal lines D from left to right. The OLED light emitting device is a current driver device. Therefore, a high-voltage signal ELVDD may be provided for the anode of the OLED light emitting device by using the pixel driver circuit, and a low-voltage signal ELVSS may be provided for the cathode of the OLED light emitting device by using the pixel driver circuit. Refer to FIG. 4. Each Micro LED pixel 21 located in the second display region 12 has a light emitting region 21a and a light transmission region 21b, and the light transmission region 21b can implement the light transmission feature of the second display region 12. After the OLED pixel is replaced with the Micro LED pixel 21 in the second display region 12, display pixels having a same area in the first display region 11 and the second display region 12 can be designed, to implement display effect consistency between the first display region 11 and the second display region 12. In addition, because a size of the Micro LED pixel 21 for light emitting is small, reducing an area of the Micro LED pixel 21 for light emitting can ensure that the Micro LED pixel 21 has a large light transmission region 21b, so that light transmittance of the second display region 12 can be improved, and a photo shooting effect of a front-facing camera can be improved. Refer to FIG. 5. The display panel 01 may further include a plurality of signal cables located on the substrate 10. The plurality of signal cables are respectively connected to the Micro LED pixels 21, and are configured to provide a drive signal for the Micro LED pixel by using the signal cable. At least a part of the plurality of signal cables are transparent cables. Apart of signal cables connected to the Micro LED pixels 21 are disposed as transparent cables, so that the light transmittance of the second display region 12 can be further improved. Specifically, the transparent cable may be made of materials such as indium tin oxide (indium tin oxide, ITO), aluminum zinc oxide (alumina zinc oxide, AZO), indium zinc oxide (indium zinc oxide, IZO), a carbon nanotube, graphene, or a silver nanowire.

Refer to FIG. 5. In an embodiment, the Micro LED pixel 21 may use a passive matrix (passive matrix, PM) manner. To be specific, no driver circuit needs to be disposed in the Micro LED pixel 21, and a Micro LED chip is directly disposed in the light emitting region 21a and is led out by using the signal cable. In this way, a quantity of cables in the second display region 12 can be reduced, and the light transmittance can be improved. The Micro LED chip disposed in the light emitting region 21a of each Micro LED pixel 21 may emit monochromatic light of different colors. For example, a Micro LED chip that emits red light, a Micro LED chip that emits blue light, a Micro LED chip that emits green light, and the like may be cyclically disposed. In FIG. 5, different filling patterns represent Micro LED chips that emit the monochromatic light of different colors.

Because the passive matrix manner is used in the second display region 12, and is different from the active matrix manner in the first display region 11, both connections and control of display pixels of the entire display panel 01 are different. Therefore, a driver chip needs to be separately provided to cooperate with the passive matrix manner used by the Micro LED pixel 21 in the second display region 12. Refer to FIG. 3. A first driver chip 41 connected to the OLED pixel 22 and a second driver chip 42 connected to the Micro LED pixel 21 by using the plurality of signal cables may be disposed. In addition, to simplify cabling complexity, the second driver chip 42 may be disposed on a frame adjacent to the second display region 12. For example, as shown in FIG. 3, the second display region 12 is disposed adjacent to an upper frame. In this case, the second driver chip 42 may be disposed on the upper frame, and the first driver chip 41 may be disposed on a lower frame.

Refer to FIG. 5. In an embodiment, when the Micro LED pixel 21 uses the passive matrix manner, the plurality of signal cables may include: a plurality of first signal cables 31 connected to first electrodes of the Micro LED chips, and a plurality of second signal cables 32 connected to second electrodes of the Micro LED chips. The first electrode that is of the Micro LED chip and that is connected to the first signal cable 31 may be an anode of the Micro LED chip, and correspondingly, the second electrode that is of the Micro LED chip and that is connected to the second signal cable 32 may be a cathode of the Micro LED chip; and vice versa. In addition, the plurality of first signal cables 31 may be disposed as transparent cables, and the transparent cable can improve the light transmittance of the second display region 12. The plurality of second signal cables 32 may be set to metal cables, and the metal cable can reduce a resistance of the cable.

Refer to FIG. 5. In an embodiment, the plurality of second signal cables 32 may be connected to each other to form a public electrode, so that second electrodes of the Micro LED chips are connected together, to load a same potential signal. For example, the potential signal may be a public potential signal. The plurality of first signal cables 31 may be independent of each other, so that the first electrode of each Micro LED chip is connected to the second driver chip 42 by using a respective first signal cable 31, to load a drive signal for display.

Because the Micro LED pixel 21 and the OLED pixel 22 have a large difference in preparation processes, a special design is required for preparing the Micro LED pixel 21 and the OLED pixel 22 on the same substrate 10. The OLED light emitting device in the first display region 11 is usually prepared in a manner of vacuum evaporation deposition, and the Micro LED chip in the second display region 12 is usually fastened by using a bonding process. In comparison with preparation of the OLED pixel 22 in the first display region 11, the Micro LED pixel 21 in the second display region 12 uses the passive matrix manner. Therefore, a component such as the TFT does not need to be prepared in the second display region 12, and only a signal cable needs to be prepared. Specifically, in a process of preparing the pixel driver circuit of the OLED pixel 22, preparation of a signal cable in the second display region 12 may be completed.

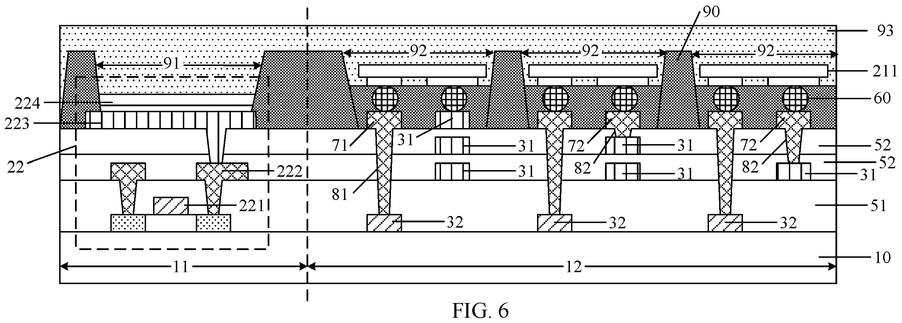

FIG. 6 is an example of a diagram of a cross-sectional structure of a display panel according to an embodiment of this application.

Refer to FIG. 6. In an embodiment, the second signal cables 32 that are connected to each other may be disposed at a same metal layer, to simplify cabling complexity. In addition, the second signal cable 32 may be prepared at a same metal layer as a metal element in the pixel driver circuit of the OLED pixel 22, for example, may be prepared at a same metal layer as a gate electrode 221 of the thin film transistor, to reduce film layer arrangement. The first signal cables 31 that are independent of each other may be disposed at at least one transparent electrode layer. In addition, the first signal cable 31 may be prepared after a dielectric layer or a planarization layer is prepared by the pixel driver circuit of the OLED pixel 22, for example, may be prepared at a same transparent electrode layer as the anode of the OLED light emitting device. Because the transparent electrode layer is prepared after the metal layer, it may be considered that there is a first insulation medium layer 51 between the metal layer and the transparent electrode layer.

Refer to FIG. 6. In an embodiment, to improve the light transmittance of the second display region 12 and simplify cabling complexity of each film layer, cabling may be performed in vertical space in a buried manner as much as possible. Therefore, the plurality of first signal cables 31 may be disposed at at least two transparent electrode layers. In the buried manner, a dielectric layer needs to be used as electrical isolation. Therefore, a second insulation medium layer 52 may be disposed between the transparent electrode layers. Specifically, the first insulation medium layer 51 and the second insulation medium layer 52 may reuse the dielectric layer in a preparation process of the OLED pixel 22. For example, after the gate electrode 221 of the thin film transistor is formed in the first display region 11 and the second signal cable 32 is formed in the second display region 12 to complete preparation of the metal layer, a first dielectric layer is prepared as the first insulation medium layer 51, source and drain electrodes 222 of the thin film transistor are prepared in the first display region 11 on the first dielectric layer, and each first signal cable 31 at a transparent electrode layer at a first layer is prepared in the second display region 12 on the first dielectric layer. Then, a second dielectric layer is prepared as the second insulation medium layer 52, one electrode (which is not shown in FIG. 6) of a capacitor is prepared in the first display region 11 on the second dielectric layer, and each first signal cable 31 at a transparent electrode layer at a second layer is prepared in the second display region 12 on the second dielectric layer. Then, a planarization layer is prepared as the second insulation medium layer 52, the anode 223 of the OLED light emitting device is prepared in the first display region 11 on the planarization layer, and each first signal cable 31 at a transparent electrode layer at a third layer (a top layer) is prepared in the second display region 12 on the planarization layer.

Refer to FIG. 6. In an embodiment, when a plurality of transparent electrode layers are disposed to prepare the first signal cable 31, to improve the light transmittance of the second display region 12, the first signal cable 31 may be superimposed in vertical space as much as possible, in other words, there is an overlapping region in the vertical space as much as possible between first signal cables 31 located at different transparent electrode layers. In addition, refer to FIG. 6. To maximize the light transmittance of the second display region 12, in an embodiment, the first signal cables 31 located at the different transparent electrode layers may be disposed in a completely overlapped manner.

Refer to FIG. 6. In an embodiment, the Micro LED chip 211 may be a flip chip, to be specific, the first electrode and the second electrode of the Micro LED chip 211 may be located on a same plane and face the substrate 10, so that the first electrode and the second electrode of the Micro LED chip 211 may be directly soldered to a corresponding signal cable by using a solder ball 60. Specifically, because a part of the first signal cables 31 and all second signal cables 32 are disposed below the transparent electrode layer at the top layer, to facilitate contact between the solder ball 60 and the signal cable, a first signal pin 71 and a second signal pin 72 that are located on a same plane as the transparent electrode layer at the top layer may be disposed, and the first signal cable 31 and the second signal cable 32 that are disposed below the transparent electrode layer at the top layer are respectively led to the same plane as the transparent electrode layer at the top layer by using the first signal pin 71 and the second signal pin 72. The second signal cable 32 may be connected to the first signal pin 71 by using a conductive material filled in a first connection hole 81 that penetrates the first insulation medium layer 51 and the second insulation medium layer 52, and a first signal cable 31 located at a transparent electrode layer at a non-top layer may be connected to the second signal pin 72 by using a conductive material filled in a second connection hole 82 that penetrates the second insulation medium layer 52. In a preparation process, after the transparent electrode layer at the top layer is prepared, the first connection hole 81 that penetrates the first insulation medium layer 51 and the second insulation medium layer 52 (to be specific, penetrates the first dielectric layer, the second dielectric layer, and the planarization layer) may be formed through an etching process, the second connection hole 82 that penetrates the second insulation medium layer 52 (to be specific, penetrates the second dielectric layer and the planarization layer, or penetrates the planarization layer) may be formed through the etching process, and the first connection hole 81 and the second connection hole 82 are filled with the conductive material, to form the first signal pin 71 and the second signal pin 72 that are located on the same plane as the transparent electrode layer at the top layer. Then, solder balls 60 may be respectively formed on the first signal pin 71, the second signal pin 72, and the first signal cable 31 located at the transparent electrode layer at the top layer, and Micro LED chips 211 are transferred to the solder balls 60 in a huge quantity, and then fastened by using a bonding process.

Refer to FIG. 6. In an embodiment, the display panel may further include a pixel definition layer 90 located on the substrate 10. The pixel definition layer 90 has a plurality of openings 91 and a plurality of grooves 92. Each opening 91 penetrates the pixel definition layer 90 in a vertical direction and is located in the first display region 11, and is configured to limit a position of the OLED light emitting device. OLED light emitting devices are located in the openings 91. Each groove 92 is located in the second display region 12, and is configured to limit a position of the Micro LED chip 211. Each groove 92 can expose a light emitting surface of the Micro LED chip 211. Specifically, in a preparation process, after the Micro LED chip 211 in the second display region 12 is fastened, the pixel definition layer 90 may be prepared on the substrate 10. A material of the pixel definition layer 90 has a light blocking function. Therefore, the pixel definition layer 90 can electrically partition the OLED light emitting device in the first display region 11, and perform optical isolation on light emitting of each Micro LED chip 211 in the second display region 12. Therefore, a height of the pixel definition layer 90 needs to be higher than the light emitting surface of each Micro LED chip 211.

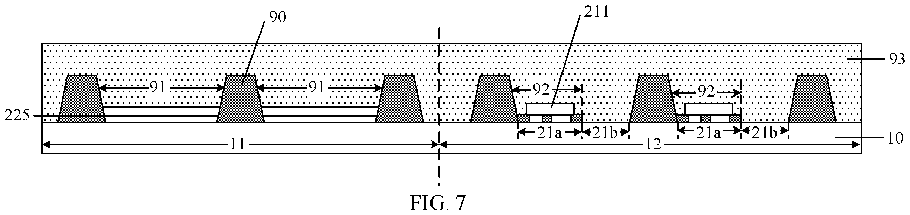

FIG. 7 is an example of a diagram of a cross-sectional structure of another display panel according to an embodiment of this application.

Refer to FIG. 7. To improve light transmittance of a second display region 12, at a pixel definition layer 90, a hole needs to be dug in a light transmission region 21b of a Micro LED pixel 21, to avoid blocking light transmission. At the pixel definition layer 90, a groove may be dug in a light emitting region 21a of the Micro LED pixel 21, as long as a light emitting surface of the Micro LED chip 211 is exposed. Refer to FIG. 6. After the pixel definition layer 90 is prepared, organic light emitting function layers 224 (for example, a hole transport layer, an electron resist layer, an organic light emitting layer, a hole blocking layer, and an electron transport layer) and a cathode (which is not shown in the figure) of an OLED light emitting device in a first display region 11 may be evaporated and deposited, to complete preparation of an OLED pixel 22 in the first display region 11.

Refer to FIG. 6 and FIG. 7. In an embodiment, the display panel 01 may further include a thin film encapsulation layer 93 located on the substrate 10. The thin film encapsulation layer 93 covers the OLED light emitting device 225, the Micro LED chip 211, and the pixel definition layer 90. The thin film encapsulation layer 93 can protect the OLED light emitting device 225 from being damaged by water vapor and oxygen, to improve use reliability. In addition, the thin film encapsulation layer 93 can also protect the Micro LED chip 211, to improve use reliability of the Micro LED chip 211.

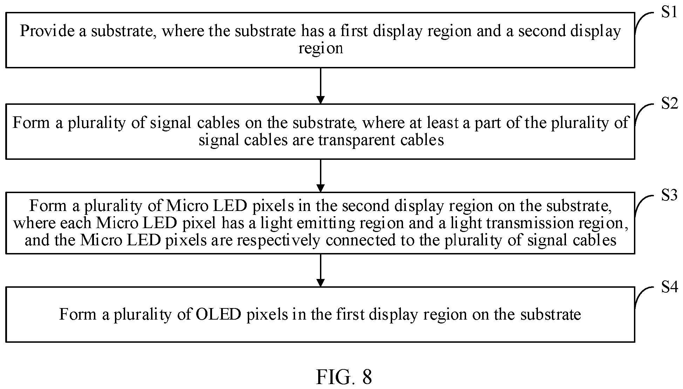

FIG. 8 is an example of a schematic flowchart of a preparation method for a display panel according to an embodiment of this application.

Based on a same invention concept, an embodiment of this application further provides a preparation method for a display panel. Refer to FIG. 8. The preparation method may include the following steps.

S1: Provide a substrate, where the substrate has a first display region and a second display region.

S2: Form a plurality of signal cables on the substrate, where at least a part of the plurality of signal cables are transparent cables.

S3: Form a plurality of Micro LED pixels in the second display region on the substrate, where each Micro LED pixel has a light emitting region and a light transmission region, and Micro LED pixels are respectively connected to the plurality of signal cables.

S4: Form a plurality of OLED pixels in the first display region on the substrate.

Specifically, in the display panel prepared by using the foregoing preparation method, after the OLED pixel is replaced with the Micro LED pixel in the second display region, display pixels having a same area in the first display region and the second display region can be designed, to implement display effect consistency between the first display region and the second display region. Because a size of the Micro LED pixel for light emitting is small, it can be ensured that the Micro LED pixel has a large light transmission region, so that light transmittance of the second display region can be improved. In addition, a part of signal cables connected to the Micro LED pixels are disposed as transparent cables, so that the light transmittance of the second display region can be further improved.

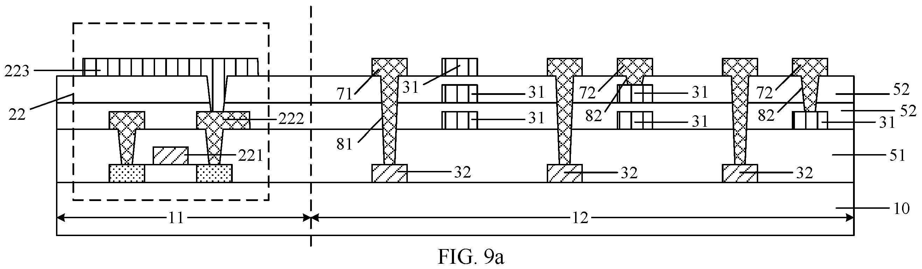

FIG. 9a to FIG. 9e are respectively examples of diagrams of cross-sectional structures after steps in a preparation method for a display panel are completed according to an embodiment of this application.

Refer to FIG. 9a. In an embodiment, a Micro LED pixel may use a passive matrix manner. To be specific, no driver circuit needs to be disposed in the Micro LED pixel, and a Micro LED chip is directly disposed in a light emitting region and is led out by using a signal cable. In this way, a quantity of cables in a second display region can be reduced, and light transmittance can be improved. A plurality of signal cables may include: a plurality of first signal cables 31 connected to first electrodes of the Micro LED chips, and a plurality of second signal cables 32 connected to second electrodes of the Micro LED chips. The first electrode that is of the Micro LED chip and that is connected to the first signal cable 31 may be an anode of the Micro LED chip, and correspondingly, the second electrode that is of the Micro LED chip and that is connected to the second signal cable 32 may be a cathode of the Micro LED chip; and vice versa. In addition, the plurality of first signal cables 31 may be disposed as transparent cables, and the transparent cable can improve the light transmittance of the second display region 12. The plurality of second signal cables 32 may be set to metal cables, and the metal cable can reduce a resistance of the cable. Further, the plurality of second signal cables 32 may be connected to each other to form a public electrode, so that second electrodes of the Micro LED chips are connected together, to load a same potential signal. For example, the potential signal may be a public potential signal. The plurality of first signal cables 31 may be independent of each other, so that the first electrode of each Micro LED chip is connected to a second driver chip 42 by using a respective first signal cable 31, to load a drive signal for display.

In comparison with preparation of the OLED pixel 22 in the first display region 11, the Micro LED pixel 21 in the second display region 12 uses the passive matrix manner. Therefore, a component such as a TFT does not need to be prepared in the second display region 12, and only a signal cable needs to be prepared. Specifically, in a process of preparing a pixel driver circuit of the OLED pixel 22, preparation of a signal cable in the second display region 12 may be completed.

Refer to FIG. 9a. In an embodiment, the second signal cables 32 that are connected to each other may be disposed at a same metal layer, to simplify cabling complexity. In addition, the second signal cable 32 may be prepared at a same metal layer as a metal element in the pixel driver circuit of the OLED pixel 22, for example, may be prepared at a same metal layer as a gate electrode 221 of the thin film transistor, to reduce film layer arrangement. The first signal cables 31 that are independent of each other may be disposed at at least one transparent electrode layer. In addition, the first signal cable 31 may be prepared after a dielectric layer or a planarization layer is prepared by the pixel driver circuit of the OLED pixel 22, for example, may be prepared at a same transparent electrode layer as an anode of an OLED light emitting device. Because the transparent electrode layer is prepared after the metal layer, it may be considered that there is a first insulation medium layer 51 between the metal layer and the transparent electrode layer.

Refer to FIG. 9a. In an embodiment, to improve the light transmittance of the second display region 12 and simplify cabling complexity of each film layer, cabling may be performed in vertical space in a buried manner as much as possible. Therefore, the plurality of first signal cables 31 may be disposed at at least two transparent electrode layers. In the buried manner, a dielectric layer needs to be used as electrical isolation. Therefore, a second insulation medium layer 52 may be disposed between the transparent electrode layers. Specifically, the first insulation medium layer 51 and the second insulation medium layer 52 may reuse the dielectric layer in a preparation process of the OLED pixel 22. For example, after the gate electrode 221 of the thin film transistor is formed in the first display region 11 and the second signal cable 32 is formed in the second display region 12 to complete preparation of the metal layer, a first dielectric layer is prepared as the first insulation medium layer 51, source and drain electrodes 222 of the thin film transistor are prepared in the first display region 11 on the first dielectric layer, and each first signal cable 31 at a transparent electrode layer at a first layer is prepared in the second display region 12 on the first dielectric layer. Then, a second dielectric layer is prepared as the second insulation medium layer 52, one electrode (which is not shown in FIG. 9a) of a capacitor is prepared in the first display region 11 on the second dielectric layer, and each first signal cable 31 at a transparent electrode layer at a second layer is prepared in the second display region 12 on the second dielectric layer. Then, a planarization layer is prepared as the second insulation medium layer 52, the anode 223 of the OLED light emitting device is prepared in the first display region 11 on the planarization layer, and each first signal cable 31 at a transparent electrode layer at a third layer (a top layer) is prepared in the second display region 12 on the planarization layer.

Refer to FIG. 9a. In an embodiment, when a plurality of transparent electrode layers are disposed to prepare the first signal cable 31, to improve the light transmittance of the second display region 12, the first signal cable 31 may be superimposed in vertical space as much as possible, in other words, there is an overlapping region in the vertical space as much as possible between first signal cables 31 located at different transparent electrode layers. In addition, refer to FIG. 9a. To maximize the light transmittance of the second display region 12, in an embodiment, the first signal cables 31 located at the different transparent electrode layers may be disposed in a completely overlapped manner.

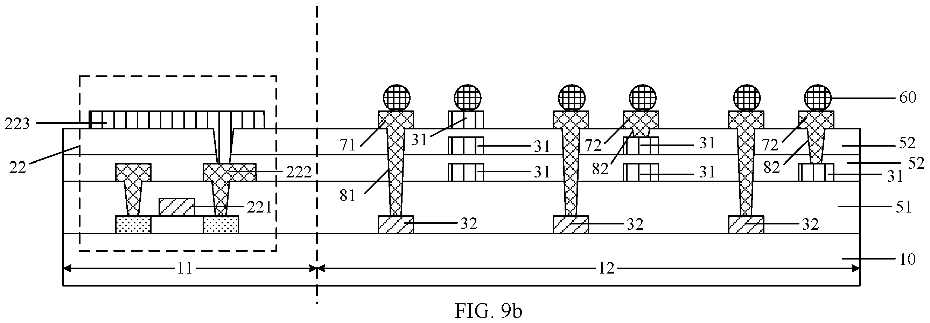

Refer to FIG. 9b. In an embodiment, because a part of the first signal cables 31 and all second signal cables 32 are disposed below the transparent electrode layer at the top layer, to facilitate contact between a solder ball 60 and the signal cable, a first signal pin 71 and a second signal pin 72 that are located on a same plane as the transparent electrode layer at the top layer may be disposed, and the first signal cable 31 and the second signal cable 32 that are disposed below the transparent electrode layer at the top layer are respectively led to the same plane as the transparent electrode layer at the top layer by using the first signal pin 71 and the second signal pin 72. The second signal cable 32 may be connected to the first signal pin 71 by using a conductive material filled in a first connection hole 81 that penetrates the first insulation medium layer 51 and the second insulation medium layer 52, and a first signal cable 31 located at a transparent electrode layer at a non-top layer may be connected to the second signal pin 72 by using a conductive material filled in a second connection hole 82 that penetrates the second insulation medium layer 52. In a preparation process, after the transparent electrode layer at the top layer is prepared, the first connection hole 81 that penetrates the first insulation medium layer 51 and the second insulation medium layer 52 (to be specific, penetrates the first dielectric layer, the second dielectric layer, and the planarization layer) may be formed through an etching process, the second connection hole 82 that penetrates the second insulation medium layer 52 (to be specific, penetrates the second dielectric layer and the planarization layer, or penetrates the planarization layer) may be formed through the etching process, and the first connection hole 81 and the second connection hole 82 are filled with the conductive material, to form the first signal pin 71 and the second signal pin 72 that are located on the same plane as the transparent electrode layer at the top layer. Then, solder balls 60 may be respectively formed on the first signal pin 71, the second signal pin 72, and the first signal cables 31 located at the transparent electrode layer at the top layer.

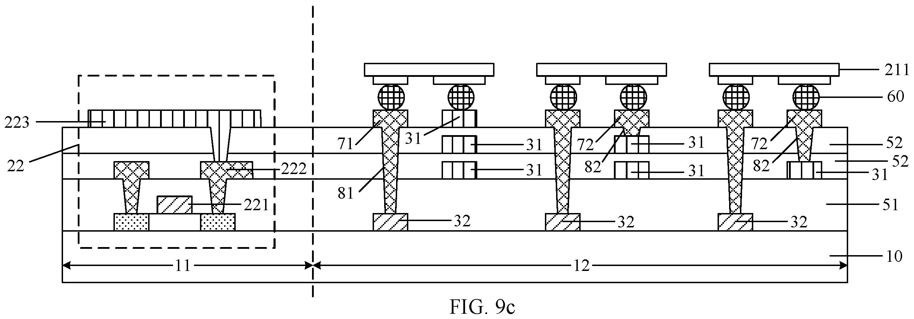

Refer to FIG. 9c. In an embodiment, the Micro LED chip 211 may be a flip chip, to be specific, the first electrode and the second electrode of the Micro LED chip 211 may be located on a same plane and face the substrate 10, so that Micro LED chips 211 are transferred to the solder balls 60 in a huge quantity, and the first electrode and the second electrode of the Micro LED chip 211 may be directly soldered to a corresponding signal cable through a bonding process by using the solder ball 60.

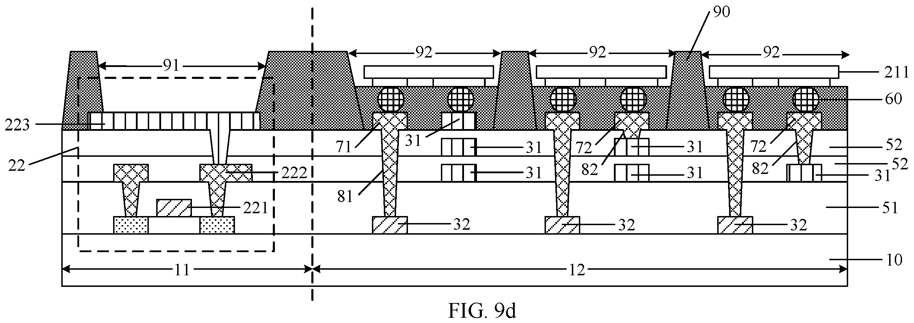

Refer to FIG. 9d. In an embodiment, after the Micro LED chip 211 in the second display region 12 is fastened, a pixel definition layer 90 may be prepared on the substrate 10. A material of the pixel definition layer 90 has a light blocking function. Therefore, the pixel definition layer 90 can electrically partition the OLED light emitting device in the first display region 11, and perform optical isolation on light emitting of each Micro LED chip 211 in the second display region 12. Therefore, a height of the pixel definition layer 90 needs to be higher than a light emitting surface of each Micro LED chip 211. To improve the light transmittance of the second display region 12, at the pixel definition layer 90, a hole needs to be dug in a light transmission region 21b of the Micro LED pixel 21, to avoid blocking light transmission. At the pixel definition layer 90, a groove may be dug in a light emitting region 21a of the Micro LED pixel 21, as long as the light emitting surface of the Micro LED chip 211 is exposed.

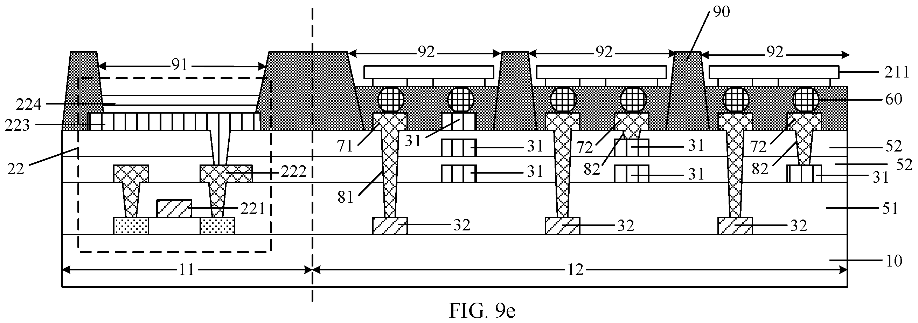

Refer to FIG. 9e. In an embodiment, after the pixel definition layer 90 is prepared, organic light emitting functions layers 224 (for example, a hole transport layer, an electron resist layer, an organic light emitting layer, a hole blocking layer, and an electron transport layer) and a cathode (which is not shown in the figure) of the OLED light emitting device in the first display region 11 may be evaporated and deposited, to complete preparation of the OLED pixel 22 in the first display region 11.

Refer to FIG. 6. In an embodiment, after the pixel definition layer 90 is prepared, a thin film encapsulation layer 93 that covers the OLED light emitting device 225, the Micro LED chip 211, and the pixel definition layer 90 may be further formed. The thin film encapsulation layer 93 can protect the OLED light emitting device 225 from being damaged by water vapor and oxygen, to improve use reliability. In addition, the thin film encapsulation layer 93 can also protect the Micro LED chip 211, to improve use reliability of the Micro LED chip 211.

In the display panel, the preparation method therefor, and the display apparatus provided in embodiments of this application, a display pixel of the first display region of the display panel may be the OLED pixel, a display pixel of the second display region may be the Micro LED pixel. The Micro LED pixel has the light emitting region and the light transmission region, and the light transmission region can implement the light transmission feature of the second display region, so that a camera is disposed below the second display region. After the OLED pixel is replaced with the Micro LED pixel in the second display region, display pixels having a same area in the first display region and the second display region can be designed, to implement display effect consistency between the first display region and the second display region. Because a size of the Micro LED pixel for light emitting is small, it can be ensured that the Micro LED pixel has a large light transmission region, so that light transmittance of the second display region can be improved. In addition, a part of signal cables connected to the Micro LED pixels are disposed as transparent cables, so that the light transmittance of the second display region can be further improved.

It is clear that a person skilled in the art can make various modifications and variations to this application without departing from the spirit and scope of this application. This application is intended to cover these modifications and variations of this application provided that they fall within the scope of protection defined by the claims and their equivalent technologies.

## Claims

1. A display panel, comprising:
a substrate, wherein the substrate has a first display region and a second display region;
a plurality of organic light emitting diode OLED pixels, located in the first display region;
a plurality of micro light emitting diode Micro LED pixels, fastened to the second display region, wherein each Micro LED pixel has a light emitting region and a light transmission region; and
a plurality of signal cables, located on the substrate, wherein the plurality of signal cables are respectively connected to the Micro LED pixels, wherein
at least a part of the plurality of signal cables are transparent cables.

2. The display panel according to claim 1, wherein the Micro LED pixel uses a passive matrix manner, and the Micro LED pixel comprises a Micro LED chip fastened to the light emitting region;
the plurality of signal cables comprise: a plurality of first signal cables connected to first electrodes of the Micro LED chips, and a plurality of second signal cables connected to second electrodes of the Micro LED chips; and
the plurality of first signal cables are transparent cables, and the plurality of second signal cables are metal cables.

3. The display panel according to claim 2, wherein the plurality of first signal cables are independent of each other, and the plurality of second signal cables are connected to each other to form a public electrode.

4. The display panel according to claim 3, wherein the second signal cable is located at a metal layer, the plurality of first signal cables are located at at least two transparent electrode layers, the metal layer is located between the substrate and the transparent electrode layer, a first insulation medium layer is provided between the metal layer and the transparent electrode layer, and a second insulation medium layer is provided between the transparent electrode layers; and
there is an overlapping region between the first signal cables located at different transparent electrode layers.

5. The display panel according to claim 4, wherein the first signal cables located at the different transparent electrode layers completely overlap.

6. The display panel according to claim 4 or 5, further comprising a first signal pin and a second signal pin that are located on a same plane as a transparent electrode layer at a top layer, wherein the second signal cable is connected to the first signal pin by using a conductive material filled in a first connection hole that penetrates the first insulation medium layer and the second insulation medium layer, and a first signal cable at a transparent electrode layer at a non-top layer is connected to the second signal pin by using a conductive material filled in a second connection hole that penetrates the second insulation medium layer.

7. The display panel according to any one of claims 2 to 6, wherein the first electrode and the second electrode of the Micro LED chip are located on a same plane and face the substrate.

8. The display panel according to any one of claims 1 to 7, further comprising a first driver chip and a second driver chip, wherein
the OLED pixel is connected to the first driver chip; and
the Micro LED pixels are connected to second driver chips by using the plurality of signal cables.

9. The display panel according to any one of claims 2 to 8, further comprising: a pixel definition layer, located on the substrate, wherein
the pixel definition layer has a plurality of openings and a plurality of grooves, OLED light emitting devices of the OLED pixels are located in the openings, and each groove exposes a light emitting surface of the Micro LED chip.

10. The display panel according to claim 9, further comprising: a thin film encapsulation layer, located on the substrate, wherein
the thin film encapsulation layer covers the OLED light emitting device, the Micro LED chip, and the pixel definition layer.

11. A display apparatus, comprising the display panel according to any one of claims 1 to 10 and a camera disposed below a second display region of the display panel.

12. A preparation method for a display panel, comprising:
providing a substrate, wherein the substrate has a first display region and a second display region;
forming a plurality of signal cables on the substrate, wherein at least a part of the plurality of signal cables are transparent cables;
forming a plurality of Micro LED pixels in the second display region on the substrate, wherein each Micro LED pixel has a light emitting region and a light transmission region, and the Micro LED pixels are respectively connected to the plurality of signal cables; and
forming a plurality of OLED pixels in the first display region on the substrate.

13. The preparation method according to claim 12, wherein the Micro LED pixel uses a passive matrix manner, the Micro LED pixel comprises a Micro LED chip fastened to the light emitting region, and the plurality of signal cables comprise: a plurality of first signal cables connected to first electrodes of the Micro LED chips, and a plurality of second signal cables connected to second electrodes of the Micro LED chips, wherein the plurality of first signal cables are transparent cables, and the plurality of second signal cables are metal cables; and
the forming a plurality of signal cables on the substrate specifically comprises:
forming a metal layer on the substrate, wherein the metal layer comprises the second signal cable;
forming a first insulation medium layer on the metal layer; and
forming at least one transparent electrode layer on the first insulation medium layer, wherein the transparent electrode layer comprises the first signal cable.

14. The preparation method according to claim 13, wherein the forming at least one transparent electrode layer on the first insulation medium layer specifically comprises:
sequentially forming at least two transparent electrode layers on the first insulation medium layer, and forming a second insulation medium layer between the transparent electrode layers, wherein the plurality of first signal cables are located at the at least two transparent electrode layers, and there is an overlapping region between the first signal cables located at different transparent electrode layers.

15. The preparation method according to claim 14, wherein after a transparent electrode layer at a top layer is formed, the method further comprises:
separately forming, through etching, a first connection hole that penetrates the first insulation medium layer and the second insulation medium layer, and a second connection hole that penetrates the second insulation medium layer; and
filling the first connection hole and the second connection hole with a conductive material, to form a first signal pin and a second signal pin that are located on a same plane as the transparent electrode layer at the top layer, so that the second signal cable is connected to the first signal pin by using a conductive material filled in the second connection hole, and a first signal cable at a transparent electrode layer at a non-top layer is connected to the second signal pin by using a conductive material filled in the second connection hole.

16. The preparation method according to claim 15, wherein the forming a plurality of Micro LED pixels in the second display region on the substrate specifically comprises:
forming, on the substrate, a plurality of solder balls that are respectively in contact with the first signal pin, the second signal pin, and a first signal cable at the transparent electrode layer at the top layer;
transferring the plurality of Micro LED chips in a huge quantity; and
bonding the plurality of solder balls and the plurality of Micro LED chips.

17. The preparation method according to any one of claims 13 to 16, wherein before the forming a plurality of OLED pixels in the first display region on the substrate, the method further comprises:
forming a pixel definition layer on the substrate, wherein the pixel definition layer has a plurality of openings and a plurality of grooves, each groove exposes a light emitting surface of the Micro LED chip, and each opening is configured to limit a position of an OLED light emitting device of each OLED pixel.

18. The preparation method according to claim 17, further comprising:
forming a thin film encapsulation layer that covers the OLED light emitting device, the Micro LED chip, and the pixel definition layer.
